# EUROPEAN PATENT SPECIFICATION

(11) **EP 3 407 691 B1**
(45) Date of publication and mention of the grant of the patent: **18.12.2019**
(21) Application number: 17172699.5
(22) Date of filing: 24.05.2017
(51) Int. Cl.: H05K 7/20, H05K 1/02

(54) **SYSTEM FOR COOLING BACKLIGHT UNITS AND ELECTRONIC BOARDS OF A DISPLAY DEVICE**
SYSTEM ZUR KÜHLUNG VON RÜCKBELEUCHTUNGSEINHEITEN UND ELEKTRONISCHER PLATTEN EINER ANZEIGEVORRICHTUNG
SYSTÈME DE REFROIDISSEMENT D'UNITÉS DE RÉTROÉCLAIRAGE ET CARTES ÉLECTRONIQUES D'UN DISPOSITIF D'AFFICHAGE

(43) Date of publication of application: 28.11.2018
(73) Proprietor: Vestel Elektronik Sanayi ve Ticaret A.S., 45030 Manisa (TR)
(72) Inventor: ELIBOL, Metehan, 45030 Manisa (TR); ÖZAYDIN, Mustafa Caglar, 45030 Manisa (TR); KARSLI, Kivanc, 45030 Manisa (TR)
(74) Representative: Ascherl, Andreas

(56) References cited:
- WO-A1-2010/029485
- US-A- 6 123 145
- US-A1- 2011 037 937
- US-A1- 2015 108 899
- US-A1- 2016 095 255
- MONGIA R K ET AL: "Heat Transfer Enhancement Using Synthetic Jets for Cooling in Low Form Factor Electronics in Presence of Mean Flow", ELECTRONICS PACKAGING TECHNOLOGY CONFERENCE, 2007. EPTC 2007. 9TH, IEEE, PISCATAWAY, NJ, USA, 10 December 2007 (2007-12-10), pages 830-835, XP031238139, ISBN: 978-1-4244-1324-9

## Description

This invention refers to a system for cooling backlight units and electronic boards of a display device according to claim 1.

### Background of the Invention

TV manufactures market drives the LED TV makers to create and design slimmer mechanics with novel design.The miniaturization of volumes, smart features and enhanced higher luminance, poses thermal originated issues in backlight and in power/main boards. Gaining higher luminance from LED chips and higher functioning CPUs bring forth the rise in chip power. The rise in chip power of advanced electronics applications requires compact and efficient solutions. Conventional cooling techniques cannot meet the next generation cooling needs. Therefore, attention has been turned to novel cooling techniques.

Specifically, two different types of BLU in LED/LCD display devices are available now in the market that includes a direct type and an edge type. The edge type display devices are further classified in to horizontal edge type and vertical edge type display device. Cooling techniques adapted for these display device includes passive cooling that is natural cooling and another one is active cooling that is forced cooling. Some drawbacks are exist when passive cooling is utilized. The main drawback is mechanical constraints. That is the shape of heatsink affects the whole system's thickness. Considering the thickness of LED bar is 0.75mm and thermal interface material (TIM) is 0.2mm and LED is 0.8mm.The tight placement limits the heatsink mechanical constraints. For direct type BLU, wide angle lens are utilised to decrease the number of LEDs in BLU and also to reduce the cost. As a consequence, the power consumption of induvidual LED incresed to achieve the light output targets for BLU. Therefore, increasing the power consumption of the LEDs also causes the local thermal hotspots need to be cooled by using active cooling methods. This cooling method will provide the reduction LEDs counts in direct type BLU and the more reliable system for direct type BLU. Mostly heatsink is not enough to effectively dissipate the heat through the system. So it limits the current and voltage that is applied to LED packages and electronic units. For instance, the reduction of the current may be essential to decrease the LED junction temperature of the backlighting system. But this decreases the total light output of back light unit (BLU). Further,the heat dissipation is limited based on material.The conductivity of material that is used as heatsink defines the resistivity value for heatsink. For efficient dissipation of heat, and to utilize high power LEDs the heat dissipating material that is frankly the heatsink must be replaced.

Usually active cooling techniques are incorporated in the display device to get better efficiency. For this type of cooling, a fan is mounted behind the backlight unit's (BLU) back cover metalto dissipate heat. But in this also some limitations are there that includes requirement for high power consumption, size is too big for using in tight back light unit (BLU) system. Further, the efficiency is also limited according to the placement, fan geometry and so on.

In the prior art KR20040052173 (A), the invention provides a back cover structure for a cooling fan.The cooling fans provided to forcibly cool the heat generated from a display unit. The back cover having a pore section that is positioned with a predetermined space from the cooling fan. The cooling fan is installed in front of the back cover. The pore sections formed in the back coverin such a manner that to allow the cooling fluid to pass through the pore section. When cooling fans driven, airflow is generated in a system. Hence, a fluid resistance is generated by the airflow. The fluid resistance in the system is estimated, thereby finding a proper operating point of the cooling fan.This patent is claimed on providing a modified backlight system to use the active cooling system (ie. a fan mounted over a heat sink).

The subject-matter of KR20040052173 (A) includes the limitation of fan mounted over the heat sink, ie. more power consumption, big size for using in tight back light unit (BLU) system, less efficiency and so on.

In the prior art WO2010/029485 a cooling device in the field of thin and flat large-area display devices is disclosed. Particularly, the device according to the invention is provided with a configuration of two walls confining a substantially closed gap-like space extending between said walls and containing a gaseous medium and is moreover provided with a synthetic jet generator for generating a gaseous synthetic jet, wherein the generator is fluidically coupled to the gas-like space.

Prior art US2016095255 discloses a cooling module, more particularly, a piezoelectric air jet with an integrated heat dissipating module to augment cooling for electronic devices within a limited space.

Prior art US6123145 discloses a fluid actuator in the form of a synthetic jet actuator for cooling heated bodies and heated fluid in open or closed systems.

### Object of the Invention

It is therefore the object of the present invention to provide a system for cooling backlight units and electronic boards of a display device, in particular a piezoelectric cooler assembly/system for cooling backlight units and ICs on electronic boards of the LED/LCD display devices.

### Summary of the Invention

The before mentioned object is solved by providing a system for cooling backlight units and electronic boards of a display device according to claim 1. In what follows, any subject-matter that is not covered by the claims should not be construed as an embodiment of the invention but as an example that is useful for understanding the invention. The system for cooling backlight units and electronic boards of a display device comprises of a plurality of heat sources of the display devices and at least a piezoelectric cooler. The piezo electric cooler can also be referred herein as synthetic jet. The plurality of heat sources of the display devices includes a plurality of LED bar in the backlight unit (BLU), a plurality of ICs on electronic boards and other optical and mechanical components. Further, the synthetic jetis provided for cooling the heat sources of the display devices.The synthetic jet is constructed by placing two piezoelectric material sandwiched between a rubber/metal cascade and form a thin chamber with an orifice at one end and a vacuum silicon structure at another end.

The placement of the synthetic jet provides an efficient cooling compared to all other cooling system. Accordingly, the synthetic jet is stationed directly near to the heat source for cooling the backlight units and electronic boards of the display device. The cooling of the display device is attained by acquiring forced air flow from the synthetic jet due to simultaneous compression and tension of the piezoelectric material by applying AC/DC voltage to the piezoelectric material.

This solution is beneficial since the size of the cooler is very thin and efficient cooling can be achieved. Therefore, the synthetic jet(piezoelectric cooler) is placed near to the heat source directly.

The synthetic jet gives beneficial results as being used with the flip chip packages at edge type backlighting systems. The flipchip packages are mounted over the PCB with the dampads which are opto-mechanical components. The slits at the dampad geometry directs the compressed air which is produced by synthetic jet, on to the flip-chip packages.

These features are beneficial since changing a frequency of the applied voltage to the piezoelectric material varies a velocity of the airflow generated by the synthetic jet.

Further benefits, goals and features of the present invention will be described by the following specification of the attached figures, in which components of the invention are exemplarily illustrated. Components of the devices and method according to the inventions, which match at least essentially with respect to their function can be marked with the same reference sign, wherein such components do not have to be marked or described in all figures.

The invention is just exemplarily described with respect to the attached figures in the following.

### Brief Description of the Drawings

- Fig. 1A: illustrates an exemplarypiezoelectric cooler or synthetic jet in expansion or ingestion mode of operation, according to the present invention;
- Fig. 1B: illustrates the exemplary piezoelectric cooler or synthetic jet in compression or expulsion mode of operation, according to the present invention;
- Fig. 2: illustrates the cross section of edge type LED TV backlight unit provided with piezoelectric cooler mounted over the heat sink, according to an embodiment of the present invention;
- Fig. 3: illustrates the cross section of edge type LED TV backlight unit provided with piezoelectric cooler placed directly near to the LED bar, according to an embodiment of the present invention;
- Fig. 4: illustrates the probable locations of the piezoelectric cooler in the heat sink of the LED TV backlight unit, according to an embodiment of the present invention;
- Fig. 5: illustrates the top view of vertical edge type backlighting unit in the LED TV provided with the piezoelectric cooler, according to an embodiment of the present invention;
- Fig. 6: Aillustrates the top view of direct type LED TV backlight unit provided with piezoelectric cooler placed directly near to the LED bar, according to an embodiment of the present invention;
- Fig. 6B: illustrates the cross section of direct type LED TV backlight unit provided with piezoelectric cooler placed directly near to the LED bar, according to an embodiment of the present invention;
- Fig. 7: illustrates the piezoelectric cooler location on the display's drivers of the display devices, according to another embodiment of the present invention;
- Fig. 8: illustrates a perspective view of flip-chip packages provided for edge type LED TV BLU, according to an embodiment of the present invention;
- Fig. 9a: illustrates a top view of flip-chip packages provided for edge type LED TV BLU, according to an embodiment of the present invention; and
- Fig. 9b: illustrates a side view of flip-chip packages provided for edge type LED TV BLU, according to an embodiment of the present invention.

### Detailed Description of the Drawings

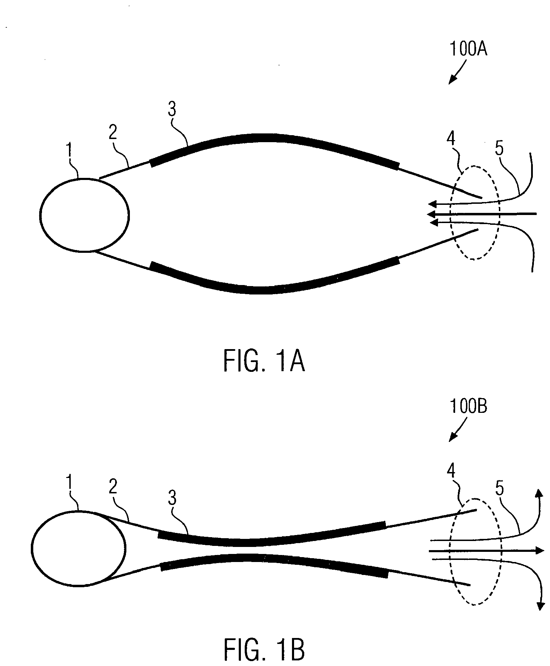

Fig. 1A illustrates a piezoelectric cooler 100A or synthetic jet in expansion or ingestion mode of operation, according to the present invention. The piezoelectric embodiment coolers are utilized for forced air-cooling for the electronic devices. The piezoelectric cooler is consturcted by placing two piezoelectric material 3 sandwiched between a rubber/metal 1 cascade and form a thin chamber with an orifice 4 at one end and a vacuum siliconrubber 1 or silicon structure 1 at another end. The piezoelectric material 3 is placed over a thin disk or blade 2. A silicon rubber 1 or an adhesive silicon material 1 separates the disk 2.The whole cooling system is a few millimeters thick and occupies very small space. The piezoelectric material 3 oscillates with variable frequency related to the AC/DC voltage applied on them. Due to that, the air velocity and amount of the air exerted from cooler can be adjusted. During expansion, the piezoelectric material 3 is stretched out and gets expanded due to the application of electrical power. At that instant, outside air may flow inside 5 the expanded thin chamber.

Fig. 1B illustrates the exemplary piezoelectric cooler 100B or synthetic jet 14 in compression or expulsion mode of operation, according to the present invention. During compression, the piezoelectric material 3 is compressed inside and blows out the air 6 (air flow outside) occupied inside the chamber due to the change in frequency of the applied electrical power. At that instant, the air present inside the chamber may blow out forcibly to the components present near to the synthetic jet 14. That is how the cooling of the BLU and display drivers of the display devices is attained by simultaneous compression and tension of the piezoelectric material 3 by applying AC/DC voltage to the piezoelectric material 3.

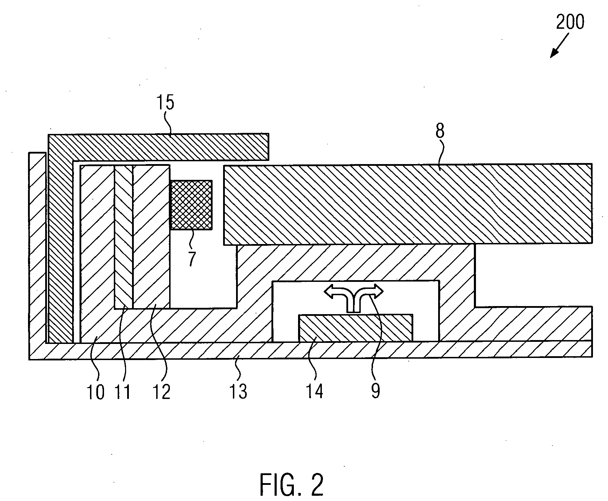

Fig. 2 illustrates the cross section 200 of edge type LED TV backlight unit provided with piezoelectric cooler mounted over the heat sink 10, according to an embodiment of the present invention.The edge type LED TV backlight unit comprises of a LED bar 7 that is fixed on to a PCB 12. The PCB 12 is attached to the heat sink 10 using a double-sided adhesive material, i.e. thermal interface material (TIM) 11. The heat sink 10 is covered with a middle frame 15 and a metal back cover 13.

The LED bar 7 generates the heat and flows into the PCB 12. The PCB 12 spreads the heat into heatsink 10 and to a double-sided adhesive material, i.e. thermal interface material (TIM) 11. The TIM 11 connects the LED bar/light array 7 to the heatsink 10. The heat transferred in a path to reach ambient by the middle frame 15, then the metal back cover 13. Further, the heat spreads to the optical components 8 by radiation of the LED bar7 and the heatsink 10. The piezoelectric cooler14 is stationed at the midst of arch-like structure of the heatsink 10. The airflow 9 generated by the piezoelectric cooler 14 is distributed to the heatsink 10, which is the main component to exert the heat caused by LED 7. The vibration at the piezoelectric materials 3 may prolong/shorten the membrane to collect/diffuse air. Manipulating the frequency of voltage applied to the piezoelectric cooler 14 can modify the air that is generated by piezoelectric cooler 14. The exerted air on heat sink 10 can reduce the temperature of the heatsink 10 by transferring the heat to nearby air molecules. Thus reduction in the total heat occurs. Considering that the total heat created by LED bar 7 is constant, the reduced heat creates drop at LED's junction and solder temperature.

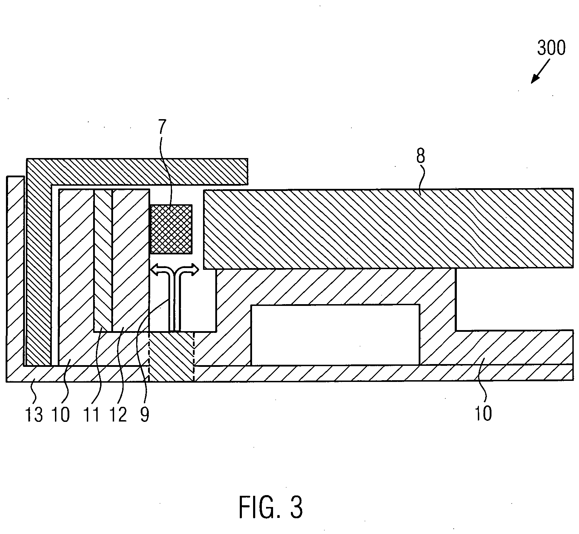

Fig. 3 illustrates the cross section 300 of edge type LED TV backlight unit provided with piezoelectric cooler placed directly near to the LED bar 7, according to an embodiment of the present invention. The more effective usage of piezoelectric cooler14 to cool the LED bar 7 is placing the synthetic jet 14 directly near to the heat source of the display device. The cooling of the BLU and electronic boards of the display device is attained by acquiring forced air flow 9 from the synthetic jet 14 due to simultaneous compression and tension of the piezoelectric material 3 by applying AC/DC voltage to the piezoelectric material 3. In this schema, the total airflow 9 is exerted on the LED bar7 to decrease the LED's solderand junction temperature. The air molecules from the synthetic jet 14 are transported to directly hit on the LED bar 7, which is the only heat source at the backlight unit (BLU).

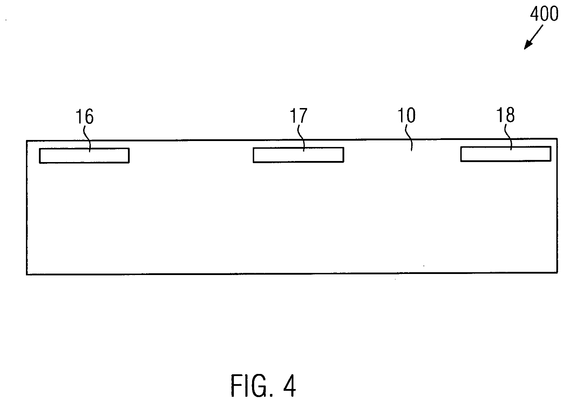

Fig. 4 illustrates the probable locations 400 of the piezoelectric coolerin the heat sink 10 of the LED TV backlight unit, according to an embodiment of the present invention. The synthetic jet 14 can be stationed above the heat sink 10 that is provided for dissipating heat from the heat source by means of forced airflow. That is for an edge type a LED display device, the synthetic jet 14 can also be mounted over the heat sink 10. The synthetic jet 14 can be placed at different locations as illustrated at 17 (16 & 18) of the heat sink 10. According to the requirement, the synthetic jet 14 can be placed at different locations as posed at the middle position of the heat sink 10 and two-side position (16 & 18) of the heat sink 10. Further, the synthetic jet 14 can also be placed near to the heat source at a bottom cover of a metal cover of the BLU of the display device.

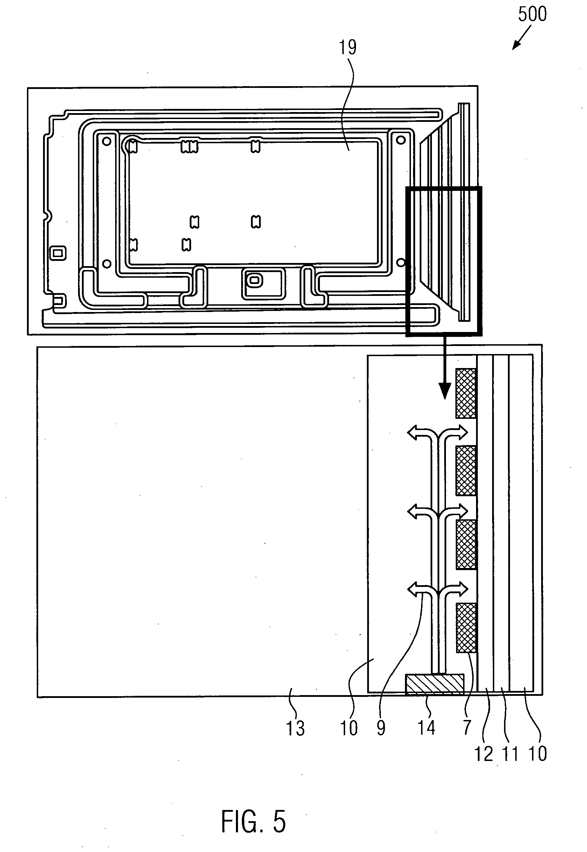

Fig. 5 illustrates the top view 500 of vertical edge type backlighting unit in the LED TV provided with the piezoelectric cooler, according to an embodiment of the present invention. At vertical type of edge type back light units, the LED bars7 are stationed vertically at the right side. In this type, the synthetic jet 14 is placed at the bottom side of the metal back cover 13 to create a turbulent air flow 9 to decrease the temperature of heatsink 10 and the LED bar 7.

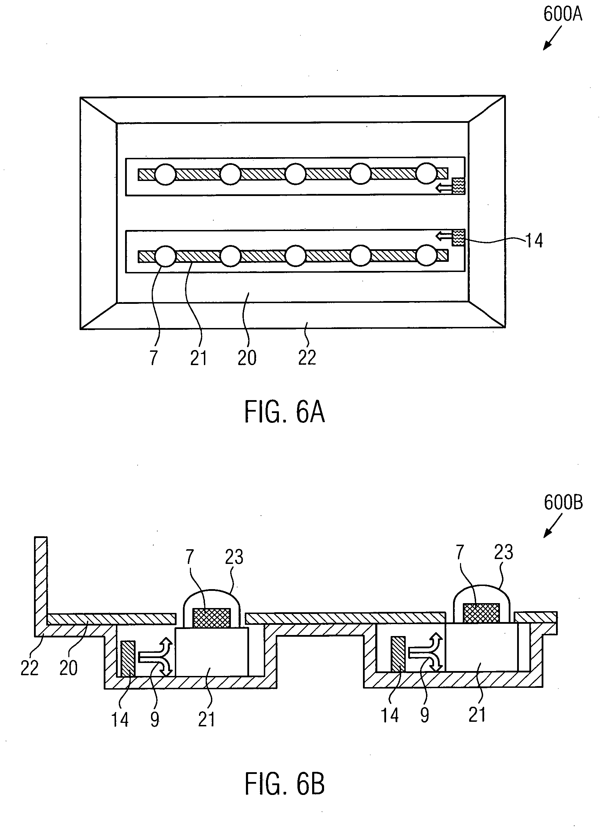

Fig. 6A illustrates the top view 600A of direct type LED TV backlight unit provided with piezoelectric cooler placed directly near to the LED bar 7, according to an embodiment of the present invention.The top view of the direct type LED TV backlight unit shows the plurality of LED bar 7 that is placed horizontally on the PCB 21. A reflector film 20 covers the base of whole arrangement. A metal back cover 22 covers the reflector film 20.

Fig. 6B illustrates the cross section 600B of direct type LED TV backlight unit provided with piezoelectric cooler placed directly near to the LED bar 7, according to an embodiment of the present invention.At the direct type LED TV backlight unit, the LED bar 7 is placed vertically or horizontally on the PCB 21. The LED bar 7 is covered with a lens 23 and surrounded by the reflector film 20. The whole set up is covered by a metal back cover 22. The piezoelectric cooler 14 is placed just at the bottom of the PCB21.The airflow 9 is targeted to cool down the PCB 21 and the LED bar 7. The PCBs 21 are placed into a slit at the direct type backlight unit. The synthetic jet 14 is placed inside the slit along with the PCB 21.

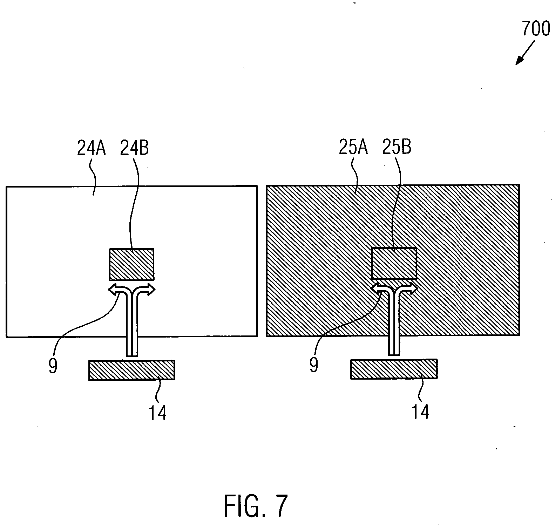

Fig. 7 illustrates the piezoelectric cooler location 700 on the display's drivers of the display devices, according to another embodiment of the present invention. The display drivers include a main board 25A and a power board 24A. The plurality of heat sources of the display drivers includes a plurality of ICs (24B & 25B ICs of the power board and the main board) on electronic boards and other optical components 8 and/or mechanical components. Further, the piezoelectric cooler/ synthetic jet 14 is provided for cooling the heat sources of the display drivers.The synthetic jet 14 is consturcted by placing two piezoelectric material 3 sandwiched between a rubber/metal cascade and form a thin chamber with an orifice 4 at one end and a vacuum silicon structure 1 at another end. The display drivers are attached to the back cover metal with screws to prevent the board components no to touch the metal back cover 13. The levitation about 5 or 6mm for boards gives enough room to install the piezoelectric cooler at the bottom side of display driver. The synthetic jet 14 with 1mm thickness can fit in. The air flow 9 that is created can easily be directed to the desired display drivers' component.

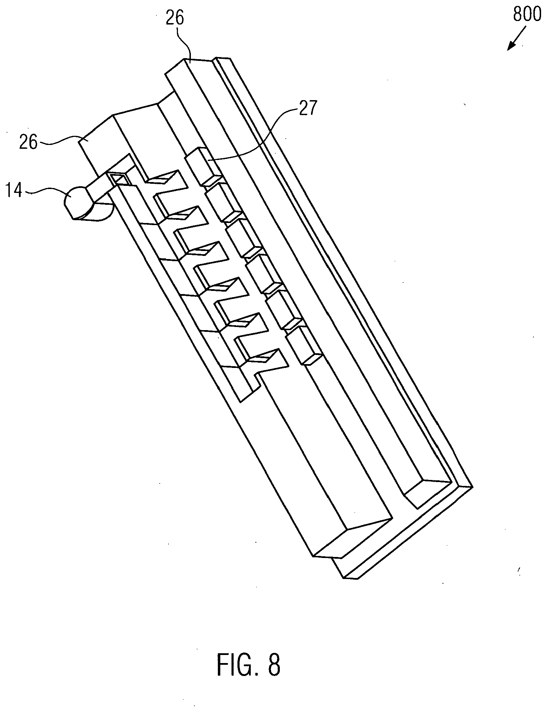

Fig. 8 illustrates a perspective view 800 of flip-chip packages provided for edge type LED TV BLU, according to an embodiment of the present invention. The synthetic jet 14 gives beneficial results as being used along with flip-chip packages 27 at the edge type backlighting systems. The flip-chip packages 27 are mounted over the PCB with the dampads 26. The dampads 26 are opto-mechanical components. The dampads 26 contains slits that are provided for directing the compressed air from the synthetic jet 14, on to the flip-chip packages 27.

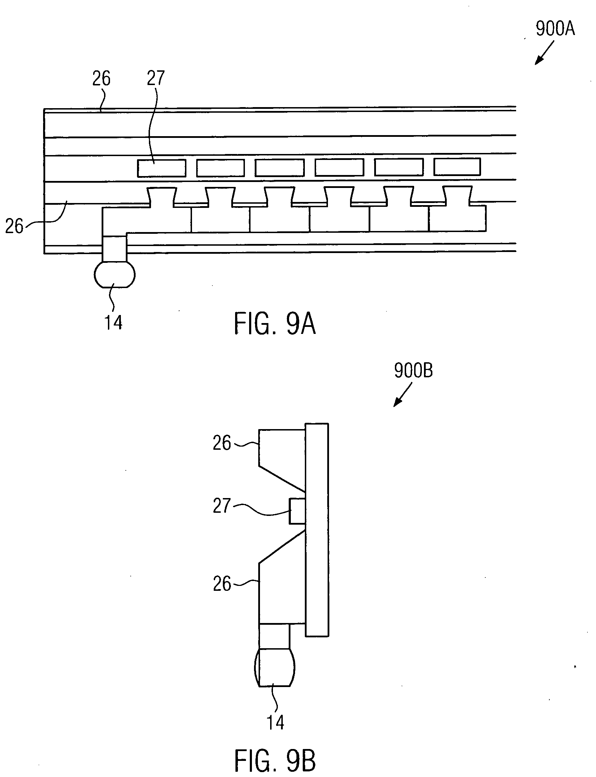

Fig. 9a and 9b illustrates a top view 900a and side view 900b of flip-chip packages provided for edge type LED TV BLU, according to an embodiment of the present invention. The figure 9a and 9b depicts the top and side view of the flip-chip packages 27 incorporated in the BLU.

Thus, the present invention refers to a system for cooling backlight units and electronic boards of a display device. The system for cooling backlight units and electronic boards of a display device comprises of a plurality of heat sources of the display devices and at least a piezoelectric cooler / synthetic jet 14. The plurality of heat sources of the display devices includes a plurality of LED bar 7 in the backlight unit (BLU), a plurality of ICs on electronic boards and other optical component 8 and mechanical components. Further, the synthetic jet 14 is provided for cooling the heat sources of the display devices. The appropriate placement of the synthetic jet 14 provides an efficient cooling compared all other cooling system. Hence, The synthetic jet 14 is stationed directly near to the heat source for cooling the backlight units and electronic boards of the display device.

### List of reference numbers

- 1: silicon rubber
- 2: blade or disk
- 3: piezoelectric material
- 4: an orifice
- 5: air flow to the thin chamber
- 6: air flow from the thin chamber
- 7: LED bar / LED
- 8: optical components
- 9: air flow
- 10: heat sink
- 11: thermal interface material (TIM)
- 12: PCB for edge type BLU
- 13: metal back cover for edge type BLU
- 14: synthetic jet or piezoelectric cooler
- 15: middle frame
- 16: one side position of the heat sink
- 17: middle position of the heat sink
- 18: another side position of the heat sink
- 19: PCB and LED bar inside the metal back cover
- 20: reflector film
- 21: PCB for the direct type BLU
- 22: metal back cover for the direct type BLU
- 23: lens covered over the LED
- 24A: power board of the display drivers
- 24B: IC for the power board
- 25A: main board of the display drivers
- 25B: IC for the main board
- 26: dampads
- 27: flip-chip packages or flip-chip
- 100: an exemplary piezoelectric cooler or synthetic jet in expansion or ingestion mode of operation
- 100A: an exemplary piezoelectric cooler or synthetic jet in compression or expulsion mode of operation
- 200: a cross section of edge type LED TV backlight unit provided with piezoelectric cooler mounted over the heat sink
- 300: a cross section of edge type LED TV backlight unit provided with piezoelectric cooler placed directly near to the LED bar
- 400: probable locations of the piezoelectric cooler in the heat sink of the LED TV backlight unit
- 500: the top view of vertical edge type backlighting unit in the LED TV provided with the piezoelectric cooler
- 600A: the top view of direct type LED TV backlight unit provided with piezoelectric cooler placed directly near to the LED bar
- 600B: the cross section of direct type LED TV backlight unit provided with piezoelectric cooler placed directly near to the LED bar
- 700: the piezoelectric cooler locationon the display's drivers of the display devices
- 800: perspective view of flip-chip packages provided for edge type LED TV BLU
- 900a: top view of flip-chip packages provided for edge type LED TV BLU
- 900b: side view of flip-chip packages provided for edge type LED TV BLU

## Claims

1. A system for cooling backlight units and electronic boards of a display device comprising a plurality of heat sources of the display devices;
wherein the plurality of heat sources of the display devices includes a plurality of LED bars (7) in the backlight unit (BLU), flip-chip packages (27) mounted over printed circuit board (12) and other optical components (8) and/or mechanical components;
wherein the system further comprises at least a synthetic jet (14) for cooling the heat sources of the display devices;
wherein the synthetic jet (14) includes two piezoelectric materials (3) sandwiched between a rubber/metal cascade (2) and form a thin chamber with an orifice (4) at one end and a vacuum silicon structure (1) at another end;
**characterized in that** the PCB (12) is provided with dampads (26) along with the flip-chip packages (27);
wherein the dampads (26) are opto-mechanical components provided with a plurality of slits;
wherein the synthetic jet (14) is stationed near to the dampads (26) which are placed along with the flip-chip packages (27) and mounted over the PCB (12) and thereby placed near to the heat source for cooling the backlight units and electronic boards of the display device; and
wherein the cooling of the backlight units and electronic boards of the display device is attained by acquiring forced air flow (9) from the synthetic jet (14) and diverting said air through the slits of the dampads (26) on to the flip-chip packages (27) and to the heat source; wherein the air flow is acquired through simultaneous compression and tension of the piezoelectric material (3) by applying AC/DC voltage to the piezoelectric material (3).

2. The system of claim 1, wherein a velocity of the air flow (9) generated by the synthetic jet (14) is varied by changing a frequency of the applied voltage to the piezoelectric material (3).

## Patentansprüche

1. System zum Kühlen von Hintergrundbeleuchtungseinheiten und elektronischen Platinen einer Anzeigevorrichtung, umfassend:
eine Vielzahl von Wärmequellen der Anzeigevorrichtungen;
wobei die Vielzahl von Wärmequellen der Anzeigevorrichtungen eine Vielzahl von LED-Leisten (7) in der Hintergrundbeleuchtungseinheit (BLU), Flip-Chip-Pakete (27), die über einer Leiterplatte (12) montiert sind, und andere optische Komponenten (8) und/oder mechanische Komponenten beinhaltet;
wobei das System ferner mindestens einen synthetischen Strahl (14) zum Kühlen der Wärmequellen der Anzeigevorrichtungen umfasst;
wobei der synthetische Strahl (14) zwei piezoelektrische Materialien (3) beinhaltet, die zwischen einer Gummi-Metall-Kaskade (2) eingeklemmt sind und eine dünne Kammer mit einer Öffnung (4) an einem Ende und einer Vakuum-Siliziumstruktur (1) an einem anderen Ende bilden;
**dadurch gekennzeichnet, dass** die Leiterplatte (12) entlang der Flip-Chip-Pakete (27) mit Dämm-pads (26) ausgestattet ist;
wobei die Dämm-pads (26) opto-mechanische Komponenten sind, die mit einer Vielzahl von Schlitzen versehen sind;
wobei der synthetische Strahl (14) in der Nähe der Dämm-pads (26) stationiert ist, die zusammen mit den Flip-Chip-Paketen (27) angeordnet sind und über der Leiterplatte (12) montiert sind und dadurch in der Nähe der Wärmequelle zum Kühlen der Backlight-Einheiten und elektronischen Platinen der Anzeigevorrichtung angeordnet sind; und
wobei die Kühlung der Hintergrundbeleuchtungseinheiten und elektronischen Platinen der Anzeigevorrichtung durch Erfassen eines Zwangsluftstroms (9) aus dem synthetischen Strahl (14) und Umlenken der Luft durch die Schlitze der Dämm-pads (26) auf die Flip-Chip-Pakete (27) und auf die Wärmequelle erreicht wird; wobei der Luftstrom durch gleichzeitige Kompression und Verspannung des piezoelektrischen Materials (3) durch Anlegen einer Wechselspannung/Gleichspannung an das piezoelektrische Material (3) erfasst wird.

2. System nach Anspruch 1, wobei eine Geschwindigkeit des durch den synthetischen Strahl (14) erzeugten Luftstroms (9) durch Ändern einer Frequenz der angelegten Spannung an das piezoelektrische Material (3) verändert wird.

## Revendications

1. Système pour refroidir des unités de rétroéclairage et des cartes électroniques d'un dispositif d'affichage comprenant :
une pluralité de sources de chaleur des dispositifs d'affichage ;
dans laquelle la pluralité de sources de chaleur des dispositifs d'affichage comprend une pluralité de barres DEL (7) dans l'unité de rétroéclairage (BLU), des boîtiers flip-chip (27) montés sur un circuit imprimé (12) et d'autres composants optiques (8) et/ou composants mécaniques ;
dans lequel le système comprend en outre au moins un jet synthétique (14) pour refroidir les sources de chaleur des dispositifs d'affichage ;
dans laquelle le jet synthétique (14) comprend deux matériaux piézoélectriques (3) pris en sandwich entre une cascade caoutchouc/métal (2) et forme une chambre mince avec un orifice (4) à une extrémité et une structure en silicium sous vide (1) à une autre extrémité ;
**caractérisé en ce que** le circuit imprimé (12) est muni les amortisseurs (26) avec les boîtiers flip-chip (27) ;
dans laquelle les amortisseurs (26) sont des composants opto-mécaniques pourvus d'une pluralité de fentes ;
dans lequel le jet synthétique (14) est placé près des amortisseurs (26) qui sont placés avec les boîtiers flip-chip (27) et montés sur le circuit imprimé (12) et ainsi placés près de la source de chaleur pour refroidir les unités de rétroéclairage et les cartes électroniques du dispositif de visualisation ; et
dans laquelle le refroidissement des unités de rétro-éclairage et des cartes électroniques du dispositif d'affichage est obtenu en acquérant un flux d'air forcé (9) à partir du jet synthétique (14) et en déviant ledit air à travers les fentes des amortisseurs (26) vers les boîtiers flip-chip (27) et vers la source de chaleur ; dans laquelle le flux d'air est acquis par compression et tension simultanées du matériau piézoélectrique (3) en appliquant une tension CA/CC sur le matériau piézoélectrique (3).

2. Système selon la revendication 1, dans lequel une vitesse du flux d'air (9) généré par le jet synthétique (14) est modifiée en changeant une fréquence de la tension appliquée au matériau piézoélectrique (3).
